**Europäisches Patentamt**

**European Patent Office**

**Office européen des brevets**

(19)

(11) Veröffentlichungsnummer: **0 088 135**
**B1**

(12) # EUROPÄISCHE PATENTSCHRIFT

(45) Veröffentlichungstag der Patentschrift:
**10.12.86**

(51) Int. Cl.⁴: **H 03 K 5/153,** G 06 F 15/20,
H 03 M 13/02

(21) Anmeldenummer: **82101667.2**

(22) Anmeldetag: **04.03.82**

(54) Integrierte Isolierschicht-Feldeffekttransistor-Schaltung für ein Eins-aus-n-System.

(43) Veröffentlichungstag der Anmeldung:
**14.09.83 Patentblatt 83/37**

(45) Bekanntmachung des Hinweises auf die Patenterteilung:
**10.12.86 Patentblatt 86/50**

(84) Benannte Vertragsstaaten:
**DE FR GB IT NL**

(56) Entgegenhaltungen:
FR - A - 1 386 494
GB - A - 2 059 708
US - A - 3 618 082
US - A - 3 732 407
US - A - 3 746 882
US - A - 3 862 440
US - A - 4 039 858

IBM TECHNICAL DISCLOSURE BULLETIN, Band 3, Nr. 6,
November 1960, Seite 55, New York, USA, e.S. WILSON:
"One and only one indicator"

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT NL**

(72) Erfinder: **Backes, Reiner, Dipl.-Ing., Am Märzengraben 2,
D-7800 Freiburg-Tiengen (DE)**

(74) Vertreter: **Morstadt, Volker, Dipl.-Ing., c/o Deutsche ITT
Industries GmbH Patent/Lizenzabteilung
Postfach 840 Hans-Bunte-Strasse 19,
D-7800 Freiburg/Brsg. (DE)**

## Beschreibung

Die Erfindung betrifft eine integrierte Isolier-schicht-Feldeffekttransistor-Schaltung, also abge-kürzt ausgedrückt eine integrierte MOS-Schaltung, zur Abgabe eines Digitalsignals bei Anlegen eines Abfrageimpulses, wenn zwischen zwei Abfragezeitpunkten ein Signalwechsel in einem Eins-aus-n-System stattgefunden hat.

Die Aufgabe der im Anspruch gekennzeich-ten Erfindung besteht darin, eine derartige MOS-Schaltung anzugeben, für die in der Praxis gelegentlich ein Bedürfnis besteht.

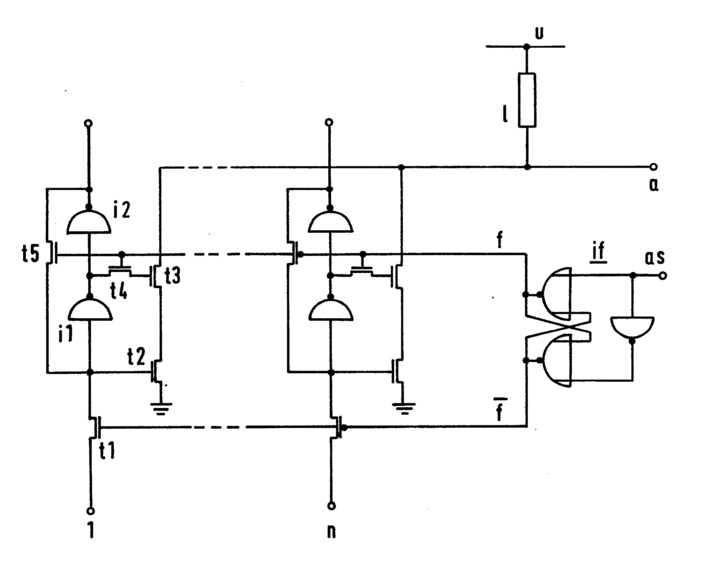

Aus der US-PS 4 039 858 ist eine Schaltung bekannt, mit der ein auf einer einzigen Eingangsleitung erfolgender Signalwechsel, z.B. die Vorder- und die Rückflanke eines Rechteckimpulses, erkannt werden kann; bei Vorder- und Rückflanke wird jeweils ein schmaler Impuls erzeugt. Die bekannte Schaltung besteht in ihrer einfachsten Form (vgl. Fig. 1 aaO) aus zwei in Serie liegenden Invertern, zwei weiteren zu einem Flipflop vereinigten Invertern einem CMOS-Transmission-Gate und einem Äquivalenzgatter (= EXNOR).

Die bekannte Anordnung ist zur Lösung der Erfindungsaufgabe ungeeignet, selbst wenn sie n-mal vorgesehen würde. Es fehlt nämlich zunächst die erforderliche Abfragetaktzuführung und auch ein Hinweis, an welcher Stelle diese Zuführung vorzunehmen ist. Ferner ist auch nicht angegeben, wie die n einzelnen bekannten Anordnungen so zu vereinigen sind, dass ein gemeinsames Ausgangssignal abgenommen werden kann.

Schliesslich dienen auch die zwei in Serie geschalteten Inverter der bekannten Anordnung nur der Ansteuerung der Gates der Transistoren des Transmissions-Gates vom Ausgangssignal der bekannten Anordnung aus.

Die Erfindung wird anhand der Figur näher erläutert, die ein schematisches Schaltbild einer Ausführungsform der Erfindung zeigt. In der Figur sind die Stufen für das erste Signal 1 und das letzte Signal n des Eins-aus-n-System gezeigt. Diese Signale liegen an den entsprechenden Klemmen. In jeder Stufe ist das entsprechende Signal über die Schaltstrecke des ersten Transistors $t1$ mit dem Eingang des ersten Inverters $i1$ und mit dem Gate des zweiten Transistors $t2$ verbunden, dessen Schaltstrecke einerseits am Schaltungsnullpunkt liegt und andererseits über die Schaltstrecke des dritten Transistors $t3$ an dem allen Signalen 1...n gemeinsam zugeordneten Lastelement 1 angeschlossen ist. Dieses liegt mit seinem anderen Anschluss an der Betriebsspannungsquelle u. Als Lastelement dient entweder ein Enhancement-Transistor oder ein Depletion-Transistor vom gleichen Kanalleitungstyp wie die erwähnten Transistoren.

Der Ausgang des ersten Inverters $i1$ liegt am Eingang des zweiten Inverters $i2$ und über die Schaltstrecke des vierten Transistors $t4$ am Gate des dritten Transistors $t3$. Der Eingang des ersten Inverters $i1$ liegt über die Schaltstrecke des fünften Transistors $t5$ am Ausgang des zweiten Inverters $i2$.

Der Abfrageimpuls as ist dem Impulsformer if zugeführt, der daraus zwei nichtüberlappende Taktsignale f, $\bar{f}$ erzeugt. Im Ausführungsbeispiel der Figur besteht der Impulsformer if aus zwei in der gezeichneten Weise kreuzgekoppelten NOR-Gattern, dessen einem eingangsseitig ein Inverter vorgeschaltet ist.

Das vom Impulsformer if erzeugte erste Taktsignal f liegt am Gate des vierten Transistors $t4$ und dem des fünften Transistors $t5$, während das er-zeugte zweite Taktsignal $\bar{f}$ dem Gate des ersten Transistors $t1$ zugeführt ist.

Zur Erläuterung der Funktionsweise wird positive Logik vorausgesetzt. Bei nicht vorhandenem Abfrageimpuls as hat somit das zweite Taktsignal $\bar{f}$ einen L-Pegel (der negativere der beiden Binärsignalpegel H, L), und somit ist der erste Transistor $t1$ gesperrt, so dass die Inverter $i1$, $i2$ über den leitenden Transistor $t5$ das Signal 1...n speichern, wie es beim letzten Abfrageimpuls as angelegen hat.

Wird nun der nächste Abfrageimpuls as angelegt, so nimmt das zweite Taktsignal $\bar{f}$ einen H-Pegel und das erste Taktsignal f L-Pegel an, wodurch der vierte und der fünfte Transistor $t4$, $t5$ gesperrt und der erste Transistor $t1$ leitend werden.

Dadurch gelangt an das Gate des zweiten Transistors $t2$ der aktuelle Pegel des Signals 1...n, während auf dem Gate des dritten Transistors $t3$ der inverse Pegel des Signals 1...n zum Zeitpunkt des vorhergehenden Abfrageimpulses as gespeichert bleibt.

Hat eines der Signale 1...n zwischen diesen beiden Abfrageimpulsen von L nach H gewechselt, so wird die Serienschaltung der Transistoren $t2$, $t3$ leitend, so dass am Ausgang a ein L-Pegel auftritt, der den stattgefundenen Signalwechsel im Eins-aus-n-System 1...n signalisiert. Dieser L-Pegel kann im Bedarfsfall mittels eines weiteren Inverters in einen H-Pegel umgewandelt werden.

Durch den fünften Transistor $t5$ wird erreicht, dass ausserhalb der Abfrageimpulse as der einmal in der Anordnung gespeicherte Binärpegel unabhängig vom Signalwechsel erhalten bleibt und dieser Signalwechsel erst zu einer Änderung des Signals am Ausgang des ersten Inverters $i1$ führt, wenn ein Abfrageimpuls as anliegt.

Die Erfindung hat unter anderem den Vorteil, dass sie auch für ein Eins-aus-n-System mit grosser Zahl n nur wenig Halbleiterkristallfläche beansprucht, da für jedes Signal des Eins-aus-n-Systems nur die Kristallfläche zweier Inverter und fünf weiterer MOS-Transistoren erforderlich ist. Es ergibt sich somit eine recht kleinflächige «Abfragezelle». Ein weiterer Vorteil der Erfindung ist, dass die Schaltung dieser Abfragezelle speicherfähig ist, so dass, wie in der Figur angedeutet ist, am Ausgang des zweiten Inverters 12 das gespeicherte Signal im Bedarfsfall für weitere Funktionen abgegriffen werden kann.

Die fünf Transistoren $t1...t5$ und die die beiden Inverter $i1$, $i2$ realisierenden Transistoren sind alle vom selben Kanalleitungstyp.

## Patentanspruch

1. Integrierte Isolierschicht-Feldeffekttransistor-Schaltung zur Abgabe eines Digitalsignals (a) bei Anlegen eines Abfrageimpulses (as), wenn zwischen zwei Abfragezeitpunkten ein Signalwechsel in einem Eins-aus-n-System stattgefunden hat, mit folgenden Merkmalen:

– jedem Signal (1...n) des Eins-aus-n-Systems sind jeweils zwei Inverter (i1, i2) und fünf Transistoren (t1...t5) derart zugeordnet,

– dass das Signal (1...n) über die Schaltstrecke des ersten Transistors (t1) mit dem Eingang des ersten Inverters (i1) und mit dem Gate des zweiten Transistors (t2) verbunden ist, dessen Schaltstrecke einerseits am Schaltungsnullpunkt liegt und andererseits über die Schaltstrecke des dritten Transistors (t3) an einem allen Signalen (1...n) gemeinsam zugeordneten Lastelement (1) angeschlossen ist, das an der Betriebsspannungsquelle (u) liegt,

– dass der Ausgang des ersten Inverters (i1) am Eingang des zweiten Inverters (i2) und über die Schaltstrecke des vierten Transistors (t4) am Gate des dritten Transistors (t3) liegt und

– dass der Eingang des ersten Inverters (i1) über die Schaltstrecke des fünften Transistors (t5) am Ausgang des zweiten Inverters (i2) liegt,

– die Abfrageimpulse (as) sind einem Impulsformer (if) zugeführt, der daraus zwei nichtüberlappende Taktsignale (f, f̄) erzeugt,

– das erste Taktsignal (f) liegt am Gate des vierten und fünften Transistors (t4, t5), und

– das zweite Taktsignal (f̄) liegt am Gate des ersten Transistors (t1).

## Claim

1. Insulated-gate field-effect transistor integrated circuit for delivering a digital signal (a) at the application of an interrogation pulse (as) if a change of state has occurred in a one-out-of-n-system until the instant of interrogation, with the following features

– to each signal (1...n) of the one-out-of-n-system there are allotted two inverters (i1, i2) and five transistors (t1...t5) in such a way

– that the signal (1...n) is applied via the channel of the first transistor (t1) to the input of the first inverter (i1) and to the gate of the second transistor (t2) whose channel is grounded at one end, while the other end is connected via the channel of the third transistor (t3) to a load device (1) common to all signals (1...n) and connected to the supply-voltage source (u),

– that the output of the first inverter (i1) is connected to the input of the second inverter (i2) and, via the channel of the fourth transistor (t4), to the gate of the third transistor (t3), and

– that the input of the first inverter (i1) is connected to the output of the second inverter (i2) via the channel of the fifth transistor (t5);

– the interrogation pulses (as) are applied to a pulse shaper (if) which produces two nonoverlapping clock signals (f, f̄) therefrom;

– the first clock signal (f) is applied to the gates of the fourth and fifth transistors (t4, t5), and

– the second clock signal (f̄) is applied to the gate of the first transistor (t1).

## Revendication

1. Circuit intégré à transistors à effet de champ à grille isolée pour délivrer un signal numérique (a) en réponse à une impulsion d'interrogation (as) si, entre deux instants d'interrogation, est intervenue une modification de signal dans un système «un parmi n», caractérisé en ce que:

– à chaque signal (1...n) du système «un parmi n» sont affectés deux inverseurs (i1, i2) et cinq transistors (t1...t5)

– le signal (1...n) est couplé, par l'intermédiaire du trajet de conduction du premier transistor (t1), à l'entrée du premier inverseur (i1) et à la grille du deuxième transistor (t2) dont le trajet de conduction est d'un côté relié à la terre, et de l'autre côté relié, par l'intermédiaire du trajet de conduction du troisième transistor, à un élément de charge (1) commun à tous les signaux (1...n) et relié à la source d'alimentation en tension,

– la sortie du premier inverseur (i1) est reliée à l'entrée du second inverseur (i2) et, par l'intermédiaire du trajet de conduction du quatrième transistor (t4), à la grille du troisième transistor, et en ce que:

– l'entrée du premier inverseur (i1) est reliée à la sortie du deuxième inverseur (i2) par l'intermédiaire du trajet de conduction du cinquième transistor (t5),

– les impulsions d'interrogation (as) sont envoyées à un conformateur d'impulsions (if) qui produit deux signaux d'horloge (f, f̄) ne se recouvrant pas,

– le premier signal d'horloge (f) étant appliqué aux grilles des quatrième et cinquième transistors, et en ce que

– le deuxième signal d'horloge (f̄) est appliqué à la grille du premier transistor (t1).